# EUROPEAN PATENT APPLICATION

(11) **EP 4 811 997 A1**
(43) Date of publication of application: **23.09.2026**
(21) Application number: 26730390.7
(22) Date of filing: 28.01.2026
(51) Int. Cl.: H10P 50/20

(54) **ETCHING GAS CONTAINING HEXAFLUORO-2-BUTYNE**

(30) Priority: 31.01.2025 JP 2025015469; 31.01.2025 JP 2025015484; 25.03.2025 JP 2025050699
(71) Applicant: DAIKIN INDUSTRIES, LTD., Osaka-Shi, Osaka 530-0001 (JP)
(72) Inventor: ETO, Yusuke, Osaka-shi, Osaka 530-0001 (JP); NAKAMURA, Shingo, Osaka-shi, Osaka 530-0001 (JP); KUROKI, Yoshichika, Osaka-shi, Osaka 530-0001 (JP); SUGIYAMA, Akinari, Osaka-shi, Osaka 530-0001 (JP)
(74) Representative: Hoffmann Eitle
(86) International application number: PCT/JP2026/002929
(87) International publication number: WO 2026/164176

(57) **Abstract**

An object of the present disclosure is to newly provide an etching gas comprising hexafluoro-2-butyne. Provided is an etching gas comprising hexafluoro-2-butyne.

## Description

### Technical Field

The present disclosure relates to an etching gas comprising hexafluoro-2-butyne.

### Background Art

PTL 1 discloses a method for producing a perfluoroalkyne compound, comprising reacting a perfluoroalkadiene compound in the presence of a catalyst to obtain a perfluoroalkyne compound; a composition comprising a perfluoroalkyne compound and a perfluorocycloalkene compound; a catalyst for use in reacting a perfluoroalkadiene compound to obtain a perfluoroalkyne compound; and a method for producing a catalyst for use in reacting a perfluoroalkadiene compound to obtain a perfluoroalkyne compound.

PTL 2 discloses a method for producing a halogenated butene compound, comprising subjecting a halogenated butane compound to a dehydrofluorination reaction; a method for producing a halogenated butyne compound, comprising subjecting a halogenated butene compound to a dehydrohalogenation reaction; and a method for producing a halogenated butyne compound, comprising subjecting a halogenated butane compound to a dehydrofluorination reaction to produce a halogenated butene compound and then subjecting the halogenated butene compound to a dehydrohalogenation reaction to produce a halogenated butyne compound.

PTL 3 discloses a method for producing a perfluorocarbon compound, comprising reacting a halogenated hydrocarbon compound in an organic solvent in the presence of an iodine-containing inorganic material and zinc or a zinc alloy to obtain a perfluorocarbon compound; and a method for producing a perfluoroalkyne compound, comprising reacting a halogenated alkene compound in at least one nitrogen-containing polar organic solvent selected from the group consisting of N,N-dimethylacetamide, N,N-diisopropylformamide, N-methyl-2-pyrrolidone, 1,3-dimethyl-3,4,5,6-tetrahydropyrimidinone, hexamethylphosphoric triamide, amine compounds, pyridine compounds, and quinoline compounds in the presence of zinc or a zinc alloy to obtain a perfluoroalkyne compound.

### Citation List

### Patent Literature

PTL 1: WO2020/075728A1
PTL 2: WO2020/171011A1
PTL 3: WO2020/204146A1

### Summary of Invention

### Technical Problem

An object of the present disclosure is to newly provide an etching gas comprising hexafluoro-2-butyne.

### Solution to Problem

The present disclosure includes the following subject matter.

### Item 1.

An etching gas comprising:
(1) 1,1,1,4,4,4-hexafluoro-2-butyne (CF₃C≡CCF₃); and
(2) at least one component selected from the group consisting of:
   (2-1) at least one metal element selected from the group consisting of a metal element in Period 3 and a metal element in Period 4; and
   (2-2) a compound having 2 or 3 carbon atoms and one double bond or triple bond.

### Item 2.

The etching gas according to Item 1, wherein based on the total amount of the etching gas,
the content of (1) the 1,1,1,4,4,4-hexafluoro-2-butyne is 99 vol% or more and 99.9995 vol% or less, and
in (2),
the content of (2-1) the metal element when present in the composition is 0.5 mass ppb or more and 40 mass ppb or less, and/or
the content of (2-2) the compound when present in the etching gas (composition) is 0.5 vol ppm or more and 95 vol ppm or less.

### Item 3.

The etching gas according to Item 1, wherein in (2), in (2-1) the metal element,
the metal element in Period 3 is at least one metal element selected from the group consisting of sodium (Na), magnesium (Mg), and aluminum (Al), and
the metal element in Period 4 is at least one metal element selected from the group consisting of calcium (Ca) and iron (Fe).

### Item 4.

The etching gas according to Item 1, wherein in (2), (2-2) the compound is at least one halogenated alkene compound selected from the group consisting of:
a halogenated ethylene compound represented by the formula CF₂=CFX, wherein X represents a hydrogen atom (H), a chlorine atom (Cl), a bromine atom (Br), or an iodine atom (I); and
hexafluoropropene (CF₃-CF=CF₂).

### Item 5.

The etching gas according to Item 1, wherein in (2), (2-2) the compound is a halogenated alkyne compound represented by the formula CF₃C≡CX, wherein X represents a hydrogen atom (H), a chlorine atom (Cl), a bromine atom (Br), or an iodine atom (I).

### Item 6.

The etching gas according to Item 1, wherein the etching gas further comprises (3) water when (2-1) the metal element in (2) is present in the etching gas (composition), and the content of (3) the water in the etching gas is 0.1 vol ppm or more and 20 vol ppm or less based on the total amount of the etching gas.

### Item 7.

An etching method comprising
etching a silicon-based material including a silicon oxide film or a silicon nitride film with a gas plasma of (A) the etching gas according to any one of Items 1 to 6.

### Item 8.

The etching method according to Item 7, wherein the silicon-based material is a substrate for producing a semiconductor.

### Item 9.

The etching method according to Item 7, wherein (A) the etching gas and (B) an inert gas are separately and continuously supplied to form a mixed etching gas within a chamber to etch the silicon-based material.

### Item 10.

The etching method according to Item 7, wherein (A) the etching gas and (C) an oxidizing gas and/or a reducing gas are separately and continuously supplied to form a mixed etching gas within a chamber to etch the silicon-based material.

### Item 11.

The etching method according to Item 7, wherein (A) the etching gas, (B) an inert gas, and (C) an oxidizing gas and/or a reducing gas are separately and continuously supplied to form a mixed etching gas within a chamber to etch the silicon-based material.

The present disclosure discloses an etching gas comprising hexafluoro-2-butyne (CF₃C≡CCF₃) . According to the present disclosure, the etching gas comprising hexafluoro-2-butyne comprises at least one metal element selected from the group consisting of a metal element in Period 3 and a metal element in Period 4, and/or comprises a compound having 2 or 3 carbon atoms and one double bond or triple bond (halogenated alkene compound (olefin compound) and/or halogenated alkyne compound). The use of such an etching gas enables favorable etching of a silicon-based material including a silicon oxide film (SiO₂ film), a silicon nitride film (SiN film), or a photoresist (PR, etching mask) material.

In the etching gas comprising hexafluoro-2-butyne of the present disclosure, in particular, the content of the metal element is adjusted to 40 mass ppb or less, whereby the metal concentration is appropriate, inclusion of metal in a formed deposited film (deposition film) is suppressed, the deposited film maintains appropriate hardness, an appropriate etching rate of an amorphous carbon layer (ACL) is maintained, and the selectivity of the SiO₂ film/ACL or the SiN film/ACL is favorable.

In the etching gas comprising hexafluoro-2-butyne of the present disclosure, in particular, the content of the metal element is adjusted to 0.5 mass ppb or more, whereby the metal concentration is appropriate, the deposited film maintains appropriate hardness, an appropriate etching rate of the SiO₂ film is maintained, and the selectivity of the SiO₂ film/ACL or the SiN film/ACL is favorable.

In the etching gas comprising hexafluoro-2-butyne of the present disclosure, in particular, the content of the compound having 2 or 3 carbon atoms and one double bond or triple bond is adjusted to 95 vol ppm or less, whereby the concentration of the compound is appropriate, the progress of PR etching caused by active species derived from double bonds (olefin) or triple bonds is suppressed, and the selectivity of the SiO₂ film/PR material is favorable. In addition, in the etching gas comprising hexafluoro-2-butyne of the present disclosure, excessive formation of deposited films (deposition films) is suppressed, and the etching rate is favorable.

In the etching gas comprising hexafluoro-2-butyne of the present disclosure, in particular, the content of the compound having 2 or 3 carbon atoms and one double bond or triple bond is adjusted to 0.5 volume ppm or more, whereby the concentration of the compound is appropriate, the protective effect by the compound is favorably maintained, and the selectivity of the SiO₂ film/PR material is favorable.

### Advantageous Effects of Invention

The present disclosure can newly provide an etching gas comprising hexafluoro-2-butyne.

### Description of Embodiments

In the present specification, the terms "comprise," "contain," and "include" encompass the concepts of comprising, consisting essentially of, and consisting of. In the present specification, a numerical range indicated by "A to B" means A or more and B or less. In the present specification, expressions such as "part(s)" and "%" denote part(s) by mass, part(s) by weight, mass percent (mass%), or weight percent (wt%).

### [1] Etching Gas

The present disclosure discloses an etching gas comprising hexafluoro-2-butyne (CF₃C=CCF₃). The etching gas of the present disclosure comprises hexafluoro-2-butyne (CF₃C≡CCF₃), and the concentration of a specific metal element, and/or the concentrations of a specific halogenated alkene compound and/or a specific halogenated alkyne compound, are adjusted, whereby polymerization (dimerization etc.) of the halogenated alkyne compound is suppressed, clogging of holes is suppressed, and degradation in etching performance is suppressed.

The etching gas of the present disclosure comprises:
(1) 1,1,1,4,4,4-hexafluoro-2-butyne (CF₃C=CCF₃); and
(2) at least one metal element selected from the group consisting of a metal element in Period 3 and a metal element in Period 4.

In the etching gas of the present disclosure, preferably, the content of (1) the 1,1,1,4,4,4-hexafluoro-2-butyne is 99 vol% or more and 99.9995 vol% or less, and the content of (2) the metal element is 0.5 mass ppb or more and 40 mass ppb or less, based on the total amount of the etching gas.

Regarding (2) the metal element in the etching gas of the present disclosure, preferably, the metal element in Period 3 is at least one metal element selected from the group consisting of sodium (Na), magnesium (Mg), and aluminum (Al), and the metal element in Period 4 is at least one metal element selected from the group consisting of calcium (Ca) and iron (Fe).

The etching gas of the present disclosure preferably further comprises (3) water. In the etching gas, the content of (3) the water is preferably 0.1 vol ppm or more and 20 vol ppm or less based on the total amount of the etching gas.

According to the present disclosure, the etching gas comprising hexafluoro-2-butyne comprises at least one metal element selected from the group consisting of a metal element in Period 3 and a metal element in Period 4. The use of such an etching gas enables favorable etching of a silicon-based material including a silicon oxide film (SiO₂ film), a silicon nitride film (SiN film), or a photoresist (PR, etching mask) material.

In the etching gas comprising hexafluoro-2-butyne of the present disclosure, in particular, the content of the metal element is adjusted to 40 mass ppb or less, whereby the metal concentration is appropriate, inclusion of metal in a formed deposited film (deposition film) is suppressed, the deposited film maintains appropriate hardness, an appropriate etching rate of an amorphous carbon layer (ACL) is maintained, and the selectivity of the SiO₂ film/ACL or the SiN film/ACL is favorable.

In the etching gas comprising hexafluoro-2-butyne of the present disclosure, in particular, the content of the metal element is adjusted to 0.5 mass ppb or more, whereby the metal concentration is appropriate, the deposited film maintains appropriate hardness, an appropriate etching rate of the SiO₂ film is maintained, and the selectivity of the SiO₂ film/ACL or the SiN film/ACL is favorable.

The etching gas of the present disclosure comprises:
(1) 1,1,1,4,4,4-hexafluoro-2-butyne (CF₃C≡CCF₃); and
(2) a compound having 2 or 3 carbon atoms and one double bond or triple bond.

In the etching gas of the present disclosure, preferably, the content of (1) the 1,1,1,4,4,4-hexafluoro-2-butyne is 99 vol% or more and 99.9995 vol% or less, and the content of (2) the compound having 2 or 3 carbon atoms and one double bond or triple bond is 0.5 vol ppm or more and 95 vol ppm or less, based on the total amount of the etching gas.

In the etching gas of the present disclosure, (2) the compound is preferably at least one halogenated alkene compound (olefin compound) selected from the group consisting of a halogenated ethylene compound represented by the formula CF₂=CFX, wherein X represents a hydrogen atom (H), a chlorine atom (Cl), a bromine atom (Br), or an iodine atom (I)), and hexafluoropropene (CF₃-CF=CF₂).

In the etching gas of the present disclosure, preferably, (2) the compound is a halogenated alkyne compound represented by formula CF₃C≡CX, wherein X represents a hydrogen atom (H), a chlorine atom (Cl), a bromine atom (Br), or an iodine atom (I).

According to the present disclosure, the etching gas comprising hexafluoro-2-butyne comprises a compound having 2 or 3 carbon atoms and one double bond or triple bond (a halogenated alkene compound and/or a halogenated alkyne compound). The use of such an etching gas enables favorable etching of a silicon-based material including a silicon oxide film (SiO₂ film), a silicon nitride film (SiN film), or a photoresist (PR, etching mask) material.

In the etching gas comprising hexafluoro-2-butyne of the present disclosure, in particular, the content of the compound having 2 or 3 carbon atoms and one double bond or triple bond is adjusted to 95 vol ppm or less, whereby the concentration of the compound is appropriate, the progress of PR etching caused by active species derived from the compound is suppressed, and the selectivity of the SiO₂ film/PR material is favorable. In addition, in the etching gas comprising hexafluoro-2-butyne of the present disclosure, excessive formation of deposited films (deposition films) is suppressed, and the etching rate is favorable.

In the etching gas comprising hexafluoro-2-butyne of the present disclosure, in particular, the content of the compound having 2 or 3 carbon atoms and one double bond or triple bond is adjusted to 0.5 vol ppm or more, whereby the concentration of the compound is appropriate, the protective effect by the compound is favorably maintained, and the selectivity of the SiO₂ film/PR material is favorable.

### (1) 1,1,1,4,4,4-Hexafluoro-2-butyne (CF₃C≡CCF₃)

The etching gas of the present disclosure comprises (1) 1,1,1,4,4,4-hexafluoro-2-butyne, which is a first component, as a main component.

In the etching gas, the content of (1) 1,1,1,4,4,4-hexafluoro-2-butyne is preferably 99 vol% or more and 99.9995 vol% or less, or 99 vol% or more and 99.999 vol% or less, more preferably 99.05 vol% to 99.995 vol%, even more preferably 99.1 vol% to 99.99 vol%, and particularly preferably 99.5 vol% to 99.95 vol%, based on the total amount (gas volume) of the etching gas, from the viewpoint of suppressing polymerization (dimerization etc.) of the halogenated alkyne compound, suppressing clogging of holes, and suppressing deterioration in etching performance.

(2) At least one component selected from the group consisting of:
(2-1) at least one metal element selected from the group consisting of a metal element in Period 3 and a metal element in Period 4; and
(2-2) a compound having 2 or 3 carbon atoms and one double bond or triple bond

### (2-1) At least one metal element selected from the group consisting of a metal element in Period 3 and a metal element in Period 4

The etching gas of the present disclosure comprises, as a second component, (2) at least one metal element selected from the group consisting of a metal element in Period 3 and a metal element in Period 4.

In (2) the metal element, the metal element in Period 3 is preferably at least one metal element selected from the group consisting of sodium (Na), magnesium (Mg), and aluminum (Al), from the viewpoint of suppressing polymerization (dimerization etc.) of the halogenated alkyne compound, suppressing clogging of holes, and suppressing deterioration in etching performance.

In (2) the metal element, the metal element in Period 4 is preferably at least one metal element selected from the group consisting of calcium (Ca) and iron (Fe), from the viewpoint of suppressing polymerization (dimerization etc.) of the halogenated alkyne compound, suppressing clogging of holes, and suppressing deterioration in etching performance.

In the etching gas, (2) the metal element may be used singly or as a mixture (blend) of two or more types.

In the etching gas, the content of (2) the metal element (when used singly or the total content when (2) the metal element is used in a combination of two or more) is preferably 0.5 mass ppb (wt ppb) or more and 40 mass ppb (wt ppb) or less, more preferably 0.75 mass ppb to 35 mass ppb, even more preferably 1 mass ppb to 30 mass ppb, and particularly preferably 1.2 mass ppb to 25 mass ppb, based on the total amount of the etching gas, from the viewpoint of suppressing polymerization (dimerization etc.) of the halogenated alkyne compound, suppressing clogging of holes, and suppressing deterioration in etching performance.

In the etching gas, 1,1,1,4,4,4-hexafluoro-2-butyne is present, and the content of the metal element is adjusted to 0.5 mass ppb or more, whereby hardening of a deposited film (deposition film) during etching is suppressed, etching rates of a SiO₂ film and a SiN film are high, and the selectivity (selectivity ratios) of the SiO₂ film/ACL and SiN film/ACL are high.

In the etching gas, 1,1,1,4,4,4-hexafluoro-2-butyne is present, and the content of the metal element is adjusted to 40 mass ppb or less, whereby inclusion of metal in a deposited film formed during etching is suppressed, the deposited film has an appropriate hardness, an etching rate of an ACL decreases, and the selectivity of the SiO₂ film/ACL and SiN film/ACL is high.

### (2-2) A compound having 2 or 3 carbon atoms and one double bond or triple bond (a halogenated alkene compound and/or a halogenated alkyne compound)

The etching gas of the present disclosure comprises, as a second component, (2) a compound having 2 or 3 carbon atoms and one double bond or triple bond (a halogenated alkene compound and/or a halogenated alkyne compound).

(2) The compound is preferably at least one halogenated alkene compound (olefin compound) selected from the group consisting of a halogenated ethylene compound represented by the formula CF₂=CFX, wherein X represents a hydrogen atom (H), a chlorine atom (Cl), a bromine atom (Br), or an iodine atom (I), and hexafluoropropene (CF₃-CF=CF₂), from the viewpoint of suppressing polymerization (dimerization etc.) of the halogenated alkyne compound (1,1,1,4,4,4-hexafluoro-2-butyne, CF₃C≡CCF₃ ), suppressing clogging of holes, and suppressing deterioration in etching performance.
(2) The compound is more preferably at least one halogenated alkene compound (olefin compound) selected from the group consisting of chlorotrifluoroethylene (CTFE) and/or hexafluoropropene (HFP), and even more preferably chlorotrifluoroethylene (CTFE), from the viewpoint of suppressing polymerization (dimerization etc.) of the halogenated alkyne compound (CF₃C≡CCF₃), suppressing clogging of holes, and suppressing deterioration in etching performance.
(2) The compound is preferably a halogenated alkyne compound represented by the formula CF₃C≡CX, wherein X represents a hydrogen atom (H), a chlorine atom (Cl), a bromine atom (Br), or an iodine atom (I), from the viewpoint of suppressing polymerization (dimerization etc.) of the halogenated alkyne compound (CF₃C≡CCF₃), suppressing clogging of holes, and suppressing deterioration in etching performance. The halogenated alkyne compound represented by the formula CF₃C≡CX may be used singly or as a mixture (blend) of two or more types.
(2) The compound is more preferably at least one halogenated alkyne compound selected from the group consisting of CF₃C≡CH, CF₃C≡CCl, and/or CF₃C≡CBr, from the viewpoint of suppressing polymerization (dimerization etc.) of the halogenated alkyne compound (CF₃C≡CCF₃), suppressing clogging of holes, and suppressing deterioration in etching performance.

In the etching gas, (2) the compound may be used singly or as a mixture (blend) of two or more types.

In the etching gas, the content of (2) the compound (when used singly or the total content when (2) the compound is used in a combination of two or more) is preferably 0.5 ppm by volume (vol ppm) or more and 95 ppm by volume (vol ppm) or less, more preferably 0.75 vol ppm to 93 vol ppm, even more preferably 1.0 vol ppm to 90 vol ppm, and particularly preferably 1.5 vol ppm to 85 vol ppm, based on the total amount of the etching gas, from the viewpoint of suppressing polymerization (dimerization etc.) of the halogenated alkyne compound (CF₃C≡CCF₃), suppressing clogging of holes, and suppressing deterioration in etching performance.

In the etching gas, 1,1,1,4,4,4-hexafluoro-2-butyne is present, and the content of (2) the compound is adjusted to 0.5 vol ppm or more, whereby a protective effect is produced during etching, and the selectivity (selectivity ratio) of the SiO₂ film/PR is high.

In the etching gas, 1,1,1,4,4,4-hexafluoro-2-butyne is present, and the content of (2) the compound is adjusted to 95 vol ppm or less, whereby the progress of PR etching caused by active species derived from (2) the compound is suppressed during etching, and the selectivity of the SiO₂ film/PR is favorable. In the etching gas, 1,1,1,4,4,4-hexafluoro-2-butyne is present, and the content of (2) the compound is adjusted to 95 vol ppm or less, whereby excessive formation of deposited films (deposition films) is suppressed during etching, and the etching rate is high.

### (3) Water

When the etching gas of the present disclosure comprises, as a second component, (2-1) at least one metal element selected from the group consisting of a metal element in Period 3 and a metal element in Period 4, the etching gas preferably further comprises (3) water as a third component, from the viewpoint of suppressing polymerization (dimerization etc.) of the halogenated alkyne compound, suppressing clogging of holes, and suppressing deterioration in etching performance.

When the etching gas comprises, as a second component, (2-1) at least one metal element selected from the group consisting of a metal element in Period 3 and a metal element in Period 4, the content of (3) water is preferably 0.1 ppm by volume (vol ppm) or more and 20 ppm by volume (vol ppm) or less, more preferably 0.5 vol ppm to 15 vol ppm, even more preferably 1 vol ppm to 10 vol ppm, and particularly preferably 1.5 vol ppm to 7.5 vol ppm, based on the total amount (gas volume) of the etching gas, from the viewpoint of suppressing polymerization (dimerization etc.) of the halogenated alkyne compound, suppressing clogging of holes, and suppressing deterioration in etching performance.

### (4) Amount of Etching Gas Used

The etching gas of the present disclosure comprises (1) 1,1,1,4,4,4-hexafluoro-2-butyne (CF₃C≡CCF₃) as a first component, (2) at least one metal element selected from the group consisting of a metal element in Period 3 and a metal element in Period 4 as a second component, and additionally (3) water.

The etching gas of the present disclosure comprises (1) 1,1,1,4,4,4-hexafluoro-2-butyne (CF₃C≡CCF₃) as a first component and (2) a compound having 2 or 3 carbon atoms and one double bond or triple bond as a second component.

The amount of the etching gas of the present disclosure used is preferably 2 ccm to 100 ccm, more preferably 5 ccm to 50 ccm, and even more preferably 8 ccm to 15 ccm, from the viewpoint of improving etching efficiency.

In the present specification, the unit "ccm" for the amount of gas used represents cubic centimeters per minute (cc/min), and denotes the volume (CC, cm³) obtained when an instantaneous flow rate is maintained for one minute under conditions converted to 25°C and 1 atm.

### (5) Other Etching Gas

The etching gas of the present disclosure may also comprise other etching gases as necessary, from the viewpoint of achieving favorable etching.

Preferable examples of other etching gases include hydrofluorocarbon compounds (HFC), such as CH₂F₂, CHF₃, C₂H₂F₂, C₂H₄F₂, and C₃H₂F₄; perfluorocarbon compounds (PFC), such as CF₄, C₂F₆, C₃F₈, C₄F₈, C₄F₆, and C₅F₈; iodides, such as CF₃I, C₂F₅I, and C₃F₇I; and SF₆. The etching rate can be adjusted by using these etching gases.

In the etching gas of the present disclosure, the other etching gases may be used singly or as a mixture (blend) of two or more types.

### [2] Method for Etching

The present disclosure includes a method for etching a substrate for producing a semiconductor using the etching gas of the present disclosure as a gas supplied to generate a plasma.

In the etching method of the present disclosure, a silicon-based material including a silicon oxide film (SiO₂ film) or a silicon nitride film (SiN film) is etched using a gas plasma generated from (A) the etching gas of the present disclosure.

The silicon-based material is preferably a substrate for producing a semiconductor.

In the etching method, preferably, (A) an etching gas and (B) an inert gas are separately and continuously supplied to form a mixed etching gas within a chamber to etch the silicon-based material.

In the etching method, preferably, (A) an etching gas and (C) an oxidizing gas and/or a reducing gas are separately and continuously supplied to form a mixed etching gas within a chamber to etch the silicon-based material.

In the etching method, preferably, (A) an etching gas, (B) an inert gas, and (C) an oxidizing gas and/or a reducing gas are separately and continuously supplied to form a mixed etching gas within a chamber to etch the silicon-based material.

The use of the etching gas of the present disclosure enables favorable hole etching of a silicon-based material including a silicon oxide film (SiO₂ film) or a silicon nitride film (SiN film) using a plasma generated from the gas while favorably maintaining the etched hole profile. The conditions for the etching method (in particular, the dry etching method) can be the same as those for conventional methods, except for using the etching gas of the present disclosure.

### (1) Examples of Etching Conditions

The etching conditions when the etching gas of the present disclosure is used are, for example, as follows.

The flow rate is adjusted to 5 ccm to 2,000 ccm, and preferably 10 ccm to 1,000 ccm.

The discharge power is adjusted to 200 W to 20,000 W, and preferably 400 W to 10,000 W. The RF power source is adjusted to 13.56 MHz and 0.22 W. The bias power is adjusted to 25 W to 15,000 W, and preferably 100 W to 10,000 W.

The pressure is adjusted to 30 mTorr or less (3.99 Pa or less), and preferably 2 mTorr to 10 mTorr (0.266 Pa to 1.33 Pa). Unless otherwise specified, the pressure indicates gauge pressure.

The electron density is adjusted to 10⁹ cm⁻³ to 10¹³ cm⁻³, and preferably 10¹⁰ cm⁻³ to 10¹² cm⁻³. The electron temperature is adjusted to 2 eV to 9 eV, and preferably 3 eV to 8 eV.

The wafer temperature is adjusted to -40°C to 100°C, and preferably -30°C to 50°C. The chamber wall temperature is adjusted to -30°C to 300°C, and preferably 20°C to 200°C.

The discharge power and the bias power also vary depending on the size of the chamber, the size of the electrodes, and the like. Preferred etching conditions for etching a pattern, such as a contact hole, in a silicon oxide film or the like using an inductively coupled plasma (ICP) etching apparatus for small-diameter wafers (chamber volume: 3,500 cm³) can be as follows.

The discharge power is adjusted to 200 W to 1,000 W, and preferably 300 W to 600 W. The bias power is adjusted to 50 W to 500 W, and preferably 100 W to 300 W.

### (2) Inert Gas

When etching is performed using the etching gas of the present disclosure, the etching gas may optionally contain an inert gas from the viewpoint of achieving favorable etching.

In the etching method, preferably, the etching gas and the inert gas are separately and continuously supplied to form a mixed etching gas within a chamber to etch a silicon-based material.

Preferably, the inert gas may contain one or more gasses such as a noble gas and nitrogen. The noble gas is preferably selected from helium, neon, argon, xenon, krypton, and the like, and the noble gas is more preferably argon (Ar).

When etching is performed using the etching gas, the inert gas may be used singly or as a mixture (blend) of two or more types.

An inert gas is capable of changing the electron temperature and electron density of plasma, and controlling the balance of fluorocarbon radicals and fluorocarbon ions.

When etching is performed using the etching gas, and the etching gas contains an inert gas (such as Ar), the amount of the inert gas used is preferably 50 ccm to 500 ccm, more preferably 150 ccm to 400 ccm, and even more preferably 220 ccm to 280 ccm, from the viewpoint of achieving favorable etching.

When etching is performed using the etching gas, and the etching gas contains an inert gas (such as Ar), the amount of the inert gas used is preferably 5 to 50 times, more preferably 15 to 40 times, and even more preferably 22 to 28 times the flow rate of the etching gas, from the viewpoint of achieving favorable etching.

### (3) Oxidizing Gas and/or Reducing Gas

When etching is performed using the etching gas of the present disclosure, the etching gas may further optionally contain an oxidizing gas and/or a reducing gas from the viewpoint of achieving favorable etching.

In the etching method, preferably, the etching gas and the oxidizing gas and/or reducing gas are separately and continuously supplied to form a mixed etching gas within a chamber to etch a silicon-based material.

The oxidizing gas is preferably O₂, O₃, NO, N₂O, NO₂, SO₂, COS, CO, CO₂, or the like, and more preferably oxygen (O₂), to obtain a favorable etching profile.

When etching is performed using the etching gas, the oxidizing gas may be used singly or as a mixture (blend) of two or more types.

When etching is performed using the etching gas, and the etching gas contains an oxidizing gas (such as O₂), the amount of the oxidizing gas used is preferably 2 sccm to 100 sccm, more preferably 5 sccm to 50 sccm, and even more preferably 8 sccm to 15 sccm, from the viewpoint of improving etching efficiency.

When etching is performed using the etching gas, and the etching gas contains an oxidizing gas (such as O₂), the amount of the oxidizing gas used is preferably 0.2 to 10 times, more preferably 0.5 to 5 times, and even more preferably 0.8 to 1.5 times the flow rate of the etching gas, from the viewpoint of improving etching efficiency.

The reducing gas is preferably hydrogen (H₂), CO, CH₄, or the like. By using such a reducing gas, a favorable etching profile can be obtained when hole etching is performed, in particular, in a silicon-based material including a silicon nitride film (SiN film).

When etching is performed using the etching gas, the reducing gas may be used singly or as a mixture (blend) of two or more types.

When etching is performed using the etching gas, and the etching gas contains a reducing gas (such as H₂), the amount of the reducing gas used is preferably 0.5 sccm to 20 sccm, more preferably 0.8 sccm to 10 sccm, and even more preferably 1 sccm to 5 sccm, from the viewpoint of improving etching efficiency.

When etching is performed using the etching gas, and the etching gas contains a reducing gas (such as H₂), the amount of the reducing gas used is preferably 0.05 to 2 times, more preferably 0.08 to 1 time, and even more preferably 0.1 to 0.5 times the flow rate of the etching gas, from the viewpoint of improving etching efficiency.

When etching is performed using the etching gas, the oxidizing gas and the reducing gas may be used singly or as a mixture (blend) of two or more types.

In the etching method, preferably, the etching gas, the inert gas, and the oxidizing gas and/or the reducing gas are separately and continuously supplied to form a mixed etching gas within a chamber to etch a silicon-based material.

### [3] Semiconductor Production Apparatus

The present disclosure includes a semiconductor production apparatus comprising a gas ejection port for the etching gas of the present disclosure.

### [4] Method of Producing Semiconductor

The present disclosure includes a method for producing a semiconductor, comprising etching a substrate for producing a semiconductor using the etching gas of the present disclosure.

### [5] Use for Semiconductor Production

The present disclosure includes use of the etching gas of the present disclosure in the production of a semiconductor, wherein etching is performed on a substrate for producing a semiconductor.

The etching gas of the present disclosure comprises (1) 1,1,1,4,4,4-hexafluoro-2-butyne (CF₃C≡CCF₃) as a first component, (2) at least one metal element selected from the group consisting of a metal element in Period 3 and a metal element in Period 4 as a second component, and additionally (3) water. By using such an etching gas of the present disclosure in hole etching, clogging of holes (hole closure) in the etched profile can be suppressed, side etching can be reduced, and a favorable etched profile of the holes (deep holes) can be maintained.

The etching gas of the present disclosure comprises (1) 1,1,1,4,4,4-hexafluoro-2-butyne (CF₃C≡CCF₃) as a first component and (2) a compound having 2 or 3 carbon atoms and one double bond or triple bond as a second component. By using such an etching gas of the present disclosure in hole etching, clogging of holes (hole closure) in the etched profile can be suppressed, side etching can be reduced, and a favorable etched profile of the holes (deep holes) can be maintained.

In the etching gas of the present disclosure, polymerization (dimerization etc.) of the halogenated alkyne compound can be suppressed, clogging of holes can be suppressed, and degradation in etching performance can be suppressed.

### Examples

The present invention is described in detail below with reference to Examples and Comparative Examples. The present invention is not limited to these Examples.

### Example 1

### Second component: at least one metal element selected from the group consisting of a metal element in Period 3 and a metal element in Period 4

### [1] Etching Method

An etching gas containing (1) 1,1,1,4,4,4-hexafluoro-2-butyne (CF₃C≡CCF₃) as a first component and (2) at least one metal element selected from the group consisting of a metal element in Period 3 and a metal element in Period 4 as a second component, and further containing (3) water was introduced through a gas inlet connected to an upper electrode, and the process gas was excited by an RF power source (13.56 MHz, 0.22 W) to perform etching.

The etching gas, oxygen (oxidizing gas), Ar (inert gas), and hydrogen (reducing gas; when etching is performed on a SiN film) were supplied through separate lines to form a mixed etching gas within a chamber, and etching was performed.

A silicon oxide film (SiO₂ film) and a silicon nitride film (SiN film) formed on a silicon-based substrate were etched using an inductively coupled plasma (ICP) under etching conditions of a discharge power of 1,000 W, a bias power of 300 W, a pressure of 10 mTorr, an electron density of 8 x 10¹⁰ cm⁻³ to 2 x 10¹¹ cm⁻³, and an electron temperature of 5 eV to 7 eV.

### [2] Measurement of Selectivity of SiO₂ film/ACL and SiN film/ACL

The selectivities of the silicon oxide film (SiO₂ film) and the silicon nitride film (SiN film) relative to the amorphous carbon layer (ACL) were determined by SEM observation of the cross-section of the silicon wafer after etching the SiO₂ film and the SiN film.

SiO₂ film/ACL: etching rate of the SiO₂ film relative to the ACL.

SiN film/ACL: etching rate of the SiN film relative to the ACL.

**Table 1**

| Table 1 | Metal concentration (wt ppb) | | | | | Total metal concentration | Water content | SiO₂/ACL | SiN/ACL |
|---|---|---|---|---|---|---|---|---|---|
| | Al | Fe | Ca | Na | Mg | | (vol ppm) | Selectivity | Selectivity |
| Ex. 1-1 | 0.1 | 0.2 | 0.2 | 0.2 | 0.1 | **0.8** | 12 | **26** | **25** |
| Ex. 1-2 | 1 | 2 | 1 | 1 | 2 | **7** | 14 | **25** | **25** |
| Ref. Ex. 1-3 | 5 | 10 | 16 | 4 | 7 | 42 | 13 | 18 | 16 |
| Ref. Ex. 1-4 | 10 | 22 | 29 | 24 | 22 | 107 | 12 | 13 | 10 |
| Ref. Ex. 1-5 | <0.1 | <0.1 | <0.1 | <0.1 | <0.1 | <0.1 | 0.05 | 20 | 17 |
| Ex. 1-6 | 0.1 | 0.2 | 0.5 | 0.2 | 0.1 | **1.1** | 8 | 25 | 26 |
| Ex. 1-7 | 1 | 2 | 1 | 1 | 2 | **7** | 3 | 25 | 24 |
| Ex. 1-8 | 0.1 | 0.1 | 0.2 | 0.2 | 0.1 | **0.7** | 0.3 | 24 | 25 |
| Ex. 1-9 | 0.1 | 0.1 | 0.2 | 0.2 | 0.1 | **0.7** | 17 | 25 | 24 |
| Ex. 1-10 | 5 | 10 | 12 | 4 | 7 | **38** | 0.3 | 24 | 24 |

When the etching gases of the Examples were used for etching the silicon-based material including a SiO₂ film and a SiN film, high selectivities of the SiO₂ film to ACL and the SiN film to ACL were achieved without degrading the etching performance.

### Example 2

### Second component: a compound having 2 or 3 carbon atoms and one double bond or triple bond (a halogenated alkene compound and/or a halogenated alkyne compound)

### [1] Etching Method

An etching gas containing (1) 1,1,1,4,4,4-hexafluoro-2-butyne (CF₃C≡CCF₃) as a first component and (2) a compound having 2 or 3 carbon atoms and one double bond or triple bond as a second component was introduced through a gas inlet connected to an upper electrode, and the process gas was excited by an RF power source (13.56 MHz, 0.22 W) to perform etching.

The etching gas, oxygen (oxidizing gas), Ar (inert gas), and hydrogen (reducing gas; when etching is performed on a SiN film) were supplied through separate lines to form a mixed etching gas within a chamber, and etching was performed.

A silicon oxide film (SiO₂ film) formed on a silicon-based substrate was etched using an inductively coupled plasma (ICP) under etching conditions of a discharge power of 1,000 W, a bias power of 300 W, a pressure of 10 mTorr, an electron density of 8 x 10¹⁰ cm⁻³ to 2 x 10¹¹ cm⁻³, and an electron temperature of 5 eV to 7 eV.

### [2] Measurement of Selectivity of SiO₂ film/PR

The selectivity of the silicon oxide film (SiO₂ film) relative to the photoresist (PR, etching mask) material was determined by SEM observation of the cross-section of the silicon oxide film after etching the SiO₂ film and the SiN film.

SiO₂ film/PR: etching rate of the SiO₂ film relative to the PR.

**Table 2**

| Table 2 | Hexafluoro -2-butyne | Halogenated alkene compound | | O₂ | Ar | Etching rate | SiO₂/PR |
|---|---|---|---|---|---|---|---|
| | Flow rate (ccm) | Type | Content (vol ppm) | Flow rate (ccm) | Flow rate (ccm) | Relative ratio to Ref. Ex. 1 | Selectivity |
| Ref. Ex. 2-1 | 20 | CTFE | 0.1 | 20 | 100 | 1.0 | 9 |
| Ex. 2-2 | 20 | CTFE | **1** | 20 | 100 | 1.0 | **16** |
| Ex. 2-3 | 20 | CTFE | **10** | 20 | 100 | 1.0 | **16** |
| Ex. 2-4 | 20 | CTFE | **50** | 20 | 100 | 1.0 | **16** |
| Ref. Ex. 2-5 | 20 | CTFE | 100 | 20 | 100 | 0.7 | 8 |
| Ref. Ex. 2-6 | 20 | HFP | 0.1 | 20 | 100 | 1.0 | 10 |
| Ex. 2-7 | 20 | HFP | 1 | 20 | 100 | 1.0 | **17** |
| Ex. 2-8 | 20 | HFP | **50** | 20 | 100 | 1.0 | **17** |
| Ref. Ex. 2-9 | 20 | HFP | 100 | 20 | 100 | 0.8 | 9 |
| Ex. 2-10 | 20 | CTFE | **92** | 20 | 100 | 1.0 | **15** |
| Ex. 2-11 | 20 | CTFE | **0.7** | 20 | 100 | 1.0 | **14** |
| Ex. 2-12 | 20 | CTFE | **1.6** | 20 | 100 | 1.0 | **17** |
| Ex. 2-13 | 20 | HFP | **91** | 20 | 100 | 1.0 | **15** |
| Ex. 2-14 | 20 | HFP | **0.8** | 20 | 100 | 1.0 | **15** |
| Ex. 2-15 | 20 | HFP | **2** | 20 | 100 | 1.0 | **18** |
| Ex. 2-16 | 20 | HFP | **0.5** | 20 | 100 | 1.0 | **14** |
| Ex. 2-17 | 5 | CTFE | **1.7** | 7 | 50 | 1.0 | **16** |
| Ex. 2-18 | 5 | HFP | **1.8** | 7 | 50 | 1.0 | **17** |

**Table 3**

| Table 3 | Hexafluoro -2-butyne | Halogenated alkyne compound | | O₂ | Ar | Etching Rate | SiO₂/PR |
|---|---|---|---|---|---|---|---|
| | Flow rate (ccm) | Type | Content (vol ppm) | Flow rate (ccm) | Flow rate (ccm) | Relative ratio to Ref. Ex. 1 | Selectivity |
| Ex. 3-19 | 20 | CF₃C≡CH | **1.9** | 20 | 100 | 1.0 | **17** |
| Ex. 3-20 | 20 | CF₃C≡CH | **0.8** | 20 | 100 | 1.0 | **16** |
| Ex. 3-21 | 20 | CF₃C≡CH | **88** | 20 | 100 | 1.0 | **17** |
| Ex. 3-22 | 20 | CF₃C≡CCl | **2** | 20 | 100 | 1.0 | **14** |
| Ex. 3-23 | 20 | CF₃C≡CCl | **93** | 20 | 100 | 1.0 | **17** |
| Ex. 3-24 | 20 | CF₃C≡CBr | **3** | 20 | 100 | 1.0 | **17** |
| Ex. 3-25 | 20 | CF₃C≡CBr | **94** | 20 | 100 | 1.0 | **16** |

When the etching gases of the Examples were used for etching the silicon-based material including a SiO₂ film, high selectivity of a SiO₂ film/PR was achieved without degrading the etching performance.

### [3] Industrial Applicability

In the etching gas of the present disclosure, the concentration of a specific metal element is adjusted, and/or a specific halogenated alkene compound and/or a halogenated alkyne compound are used and the concentrations thereof are adjusted, whereby polymerization (dimerization etc.) of the halogenated alkyne compound is suppressed, clogging of holes is suppressed, and degradation in etching performance is suppressed.

The etching gas of the present disclosure comprises hexafluoro-2-butyne, as well as at least one component selected from the group consisting of at least one metal element selected from the group consisting of a metal element in Period 3 and a metal element in Period 4, and a compound having 2 or 3 carbon atoms and one double bond or triple bond. The use of such an etching gas enables favorable etching of a silicon-based material including a silicon oxide film (SiO₂ film), a silicon nitride film (SiN film), or a photoresist (PR, etching mask) material.

In the etching gas comprising hexafluoro-2-butyne of the present disclosure, in particular, the content of the metal element is adjusted to 40 mass ppb or less, whereby the metal concentration is appropriate, inclusion of metal in a formed deposited film (deposition film) is suppressed, the deposited film maintains appropriate hardness, an appropriate etching rate of an amorphous carbon layer (ACL) is maintained, and the selectivity of the SiO₂ film/ACL or the SiN film/ACL is favorable.

In the etching gas comprising hexafluoro-2-butyne of the present disclosure, in particular, the content of the metal element is adjusted to 0.5 mass ppb or more, whereby the metal concentration is appropriate, the deposited film maintains appropriate hardness, an appropriate etching rate of the SiO₂ film is maintained, and the selectivity of the SiO₂ film/ACL or the SiN film/ACL is favorable.

In the etching gas comprising hexafluoro-2-butyne of the present disclosure, in particular, the content of the compound having 2 or 3 carbon atoms and one double bond or triple bond is adjusted to 95 vol ppm or less, whereby the concentration of the compound is appropriate, the progress of PR etching caused by active species derived from the compound (halogenated alkene compound and/or halogenated alkyne compound) is suppressed, and the selectivity of the SiO₂ film/PR material is favorable. In addition, in the etching gas comprising hexafluoro-2-butyne of the present disclosure, excessive formation of deposited films (deposition films) is suppressed, and the etching rate is favorable.

In the etching gas comprising hexafluoro-2-butyne of the present disclosure, in particular, the content of the compound having 2 or 3 carbon atoms and one double bond or triple bond is adjusted to 0.5 vol ppm or more, whereby the concentration of the compound is appropriate, the protective effect by the compound (halogenated alkene compound (olefin compound) and/or halogenated alkyne compound) is maintained, and the selectivity of the SiO₂ film/PR material is favorable.

## Claims

1. An etching gas comprising:
(1) 1,1,1,4,4,4-hexafluoro-2-butyne (CF₃C≡CCF₃); and
(2) at least one component selected from the group consisting of:
(2-1) at least one metal element selected from the group consisting of a metal element in Period 3 and a metal element in Period 4; and
(2-2) a compound having 2 or 3 carbon atoms and one double bond or triple bond.

2. The etching gas according to claim 1, wherein based on the total amount of the etching gas,
the content of (1) the 1,1,1,4,4,4-hexafluoro-2-butyne is 99 vol% or more and 99.9995 vol% or less, and
in (2),
the content of (2-1) the metal element when present in the composition is 0.5 mass ppb or more and 40 mass ppb or less, and/or
the content of (2-2) the compound when present in the composition is 0.5 vol ppm or more and 95 vol ppm or less.

3. The etching gas according to claim 1, wherein in (2), in (2-1) the metal element,
the metal element in Period 3 is at least one metal element selected from the group consisting of sodium (Na), magnesium (Mg), and aluminum (Al), and
the metal element in Period 4 is at least one metal element selected from the group consisting of calcium (Ca) and iron (Fe).

4. The etching gas according to claim 1, wherein in (2), (2-2) the compound is at least one halogenated alkene compound selected from the group consisting of:
a halogenated ethylene compound represented by the formula CF₂=CFX, wherein X represents a hydrogen atom (H), a chlorine atom (Cl), a bromine atom (Br), or an iodine atom (I); and
hexafluoropropene (CF₃-CF=CF₂).

5. The etching gas according to claim 1, wherein in (2), (2-2) the compound is a halogenated alkyne compound represented by the formula CF₃C≡CX, wherein X represents a hydrogen atom (H), a chlorine atom (Cl), a bromine atom (Br), or an iodine atom (I).

6. The etching gas according to claim 1, wherein the etching gas further comprises (3) water when (2-1) the metal element in (2) is present in the composition, and the content of (3) the water in the etching gas is 0.1 vol ppm or more and 20 vol ppm or less based on the total amount of the etching gas.

7. An etching method comprising
etching a silicon-based material including a silicon oxide film or a silicon nitride film with a gas plasma of (A) the etching gas according to any one of claims 1 to 6.

8. The etching method according to claim 7, wherein the silicon-based material is a substrate for producing a semiconductor.

9. The etching method according to claim 7, wherein (A) the etching gas and (B) an inert gas are separately and continuously supplied to form a mixed etching gas within a chamber to etch the silicon-based material.

10. The etching method according to claim 7, wherein (A) the etching gas and (C) an oxidizing gas and/or a reducing gas are separately and continuously supplied to form a mixed etching gas within a chamber to etch the silicon-based material.

11. The etching method according to claim 7, wherein (A) the etching gas, (B) an inert gas, and (C) an oxidizing gas and/or a reducing gas are separately and continuously supplied to form a mixed etching gas within a chamber to etch the silicon-based material.
